# EUROPEAN PATENT APPLICATION

(11) **EP 0 668 371 A1**
(43) Date of publication of application: **23.08.1995**
(21) Application number: 95300515.4
(22) Date of filing: 27.01.1995
(51) Int. Cl.: C23C 16/26

(54) **Semi-transparent diamond film**

(30) Priority: 16.02.1994 US 195672
(71) Applicant: GENERAL ELECTRIC COMPANY, Schenectady, NY 12345 (US)
(72) Inventor: Anthony, Thomas Richard, Schenectady, New York 12309 (US); Fleischer, James Fulton, Scotia, New York 12302 (US)
(74) Representative: Szary, Anne Catherine

(57) **Abstract**

A method is provided for making semi-transparent polycrystalline diamond film having a thickness greater than 50 microns which can be used as a heat sink in microelectronic applications. A mixture of hydrogen and a carbon-chlorine containing material such as carbon tetrachloride is conveyed into a heated filament reaction zone adjacent to an appropriate substrate, such as molybdenum to produce non-adherent semi-transparent diamond film.

## Description

### Reference to Related Application

Reference is made to copending application RD-23106 filed concurrently herewith (US Serial No. 08/195,673).

### Background of the Invention

The present invention relates to a chemical vapor deposition (CVD) method for making semi-transparent free standing polycrystalline diamond film. More particularly, the present invention relates to the formation of diamond film using a mixture of hydrogen and a carbon polychloride, such as carbon tetrachloride, in a heated reaction zone adjacent to a substrate such as molybdenum.

As shown by Anthony et al, U.S. patent 5,110,579, which is incorporated herein by reference, continuous free-standing substantially transparent diamond film can be made by utilizing a mixture of hydrogen and methane in a heated reaction zone. It has been found that diamond films made from hydrogenmethane mixtures can have various degrees of transparency depending upon such factors as film thickness, the volume % of the methane used in the reaction mixture during film formation etc. As discussed in U.S. 5,110,579, dissociation of hydrogen atoms and methane in a heated reaction zone is sufficient to generate active carbon-hydrogen species leading to diamond film formation. It would be desirable to provide additional procedures for making free-standing semi-transparent diamond films.

### Summary of the Invention

The present invention is based on the discovery that free-standing, substantially transparent, semi-transparent, or translucent polycrystalline diamond film, having a thickness of at least 50 microns, such as a thickness of up to 5000 microns, and more particularly 200 to 1000 microns can be made by using a mixture of hydrogen and a carbon polychloride, such as carbon tetrachloride, in a heated reaction zone. It has been found that diamond film made in accordance with the practice of the invention has an improved degree of "optical transparency". The term optical transparency used to establish the degree of transparency of diamond film made in accordance with the practice of the invention is an empirical definition. The optical transparency of an unevaluated diamond film is determined by comparing it with a standard transparent diamond film having a comparable thickness. For definition purposes, a standard diamond film is a diamond film made in accordance with the procedure shown by Anthony et al, U.S. patent 5,110,579. In evaluating a diamond film for degree of optical transparency, the film to be evaluated should have about the same thickness as the standard. The optical transparency of the standard can be determined under a visible light source such as fluorescent light. Printed text, such as a U.S.patent, can be read through the diamonds. A side by side comparison of the clarity of the printed text provides an empirical determination of the degree of optical transparency of the evaluated diamond against the standard.

### Statement of the Invention

There is provided by the present invention, a continuous free-standing, polycrystalline diamond film having a thickness of at least 50 microns comprising (A) substantially vertical columnar diamond crystals having a <110> orientation perpendicular to the base and up to 10,000 parts per million of chemically combined chlorine atoms, or a mixture of chlorine atoms and hydrogen atoms which are sufficient to substantially saturate dangling carbon atoms at diamond crystal grain boundaries, carbon dislocations, and carbon valance vacancies and (B) diamond crystal grain boundaries separating the columnar diamond crystals of (A), where the diamond crystal grain boundaries have a 70°-90° orientation to the diamond crystal base.

In an another aspect of the present invention, there is provided a method of making a non-adherent free-standing, semi-transparent polycrystalline diamond film on a substrate which method comprises, passing a mixture of hydrogen and a carbon-chlorine containing material through a heated reaction zone at a temperature of about 700°C to about 900°C and at a pressure from about 3 to about 24 torr which is sufficient to generate active atomic species comprising carbon-Cl species, or a mixture of carbon-Cl and carbon-hydrogen species, and the heated reaction zone is maintained at a distance of from about 0.3 to about 1 centimeter from the surface of the substrate, where the carbon-chlorine containing material is a member selected from the group consisting of,
(a) a carbon polychloride, C(H)ₐCl₄₋ₐ, where "a" is a whole number equal to 0 to 3 inclusive, and
(b) a mixture of the carbon polychloride and methane,

and the carbon-chlorine containing material introduced into the heated reaction zone is present at from about 0.1 to about 2 volume percent of carbon-chlorine containing material, based on the total volume of hydrogen and carbon-chlorine containing material in the mixture.

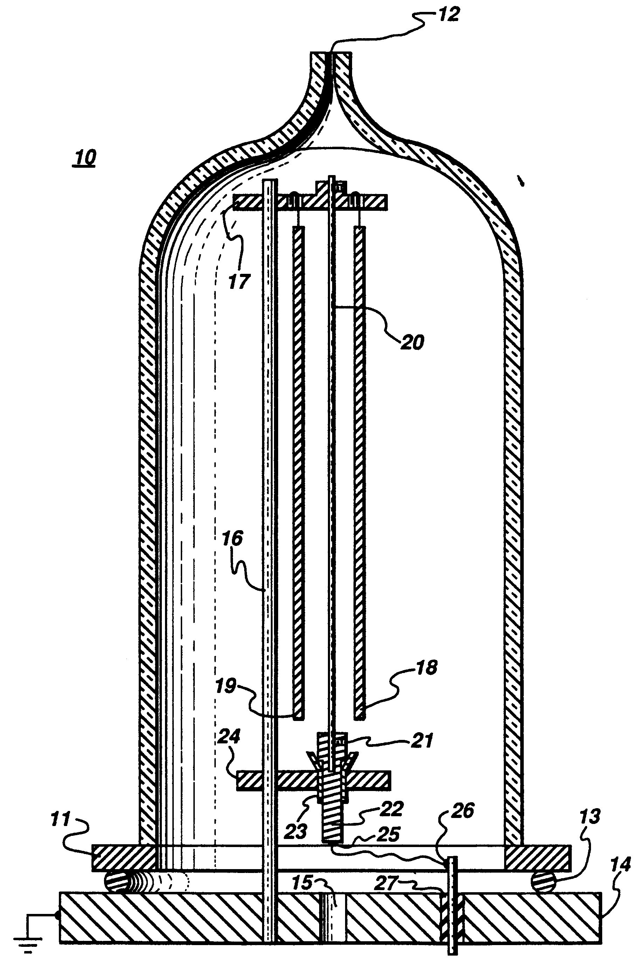

### Brief Description of the Drawing

A typical apparatus which can be used to form the transparent polycrystalline diamond film of the present invention is shown by the drawing. The drawing shows a quartz bell jar having a metal flange which rests on a base. Inside the quartz bell jar, there is shown a support structure for a filament and several adjacent substrate sections.

More particularly, there is shown in the drawing a quartz bell jar at **10** which is 20''-30'' tall and about 4''-6'' wide having a metal collar at its base at **11** and a gas inlet at the top at **12**. The metal collar portion rests on a rubber seal at **13** which can be Neoprene rubber. The rubber seal is supported by a metal base, such as steel base structure at **14** which has a vacuum opening at **15**.

Inside the quartz bell jar there is shown a supporting stand at **16** for an extension at **17** for holding several substrate structures, such as molybdenum at **18** and **19** and a filament at **20**. The filament is secured by a screw at **21** to a metal plug at **22** which passes through a quartz insulating collar at **23** which is supported by an extension at **24**. Electrical contacts are shown from the plug at **25** to a stud at **26** which is insulated from the metal base at **27**.

A detailed discussion of Miller Indices describing crystal planes of atoms differentiating between <010>, <110> and <111> orientation is shown on pages 65-69 in *Elements of Material Science*, Second Edition, 1964, by Lawrence H. VanVlack of Addison-Wisley Publishing Company, Reading, Mass. which is incorporated herein by reference.

The polycrystalline diamond films made in accordance with the practice of the present invention can be used in a variety of glazing applications as well as heat sinks or semiconductors.

In order that those skilled in the art will be better able to practice the present invention, the following example is given by way of illustration and not by way of limitation.

### Example

A mixture of 1 volume % methane, 0.5 volume % carbon tetrachloride, and 98.5 volume % hydrogen measured under atmospheric conditions was introduced into a reaction vessel as shown by in the drawing. A gas flow rate of about 400 cubic centimeters per minute was maintained. There was used two 1 1/4'' X 1/4'' X 9'' molybdenum substrates and two 24 centimeters long 218 tungsten filament having diameters of 0.016''. The tungsten filament was maintained at a temperature between about 2000°C to 2100°C. A separation of about 10 millimeters was maintained between the filament and the molybdenum substrate during the deposition which lasted about 24 days. The substrate temperature was estimated at about 705°C during the deposition period.

At the termination of the deposition period, the apparatus was allowed to cool to room temperature. Transparent diamond films, referred to hereinafter as the "chlorinated diamond film" having thicknesses of about 275 microns separated from the substrate during the cooling period.

A transparent diamond film is prepared in accordance with the method of Anthony et al, U.S. 5,110,579. In preparing the diamond film, a reaction mixture is used consisting of about 1.5 volume % of methane and 98.5 volume % of hydrogen. There is obtained a free-standing, polycrystalline, transparent diamond film, having a thickness substantially the same as the chlorinated diamond film and referred to hereinafter as the "diamond film standard". The optical transparency of the chlorinated diamond film was found to be substantially greater than the standard diamond film based on the clarity of printed text which was read when the films were placed under fluorescent light. In addition, the appearance of the chlorinated diamond film was whiter than the standard.

Although the above example is directed to only a few of the very many variables which can be used in the practice of the invention, additional parameters can be found in the description preceding this example.

## Claims

1. A continuous free-standing, polycrystalline diamond film having a thickness of at least 50 microns comprising (A) substantially vertical columnar diamond crystals having a <110> orientation perpendicular to the base and up to 10,000 parts per million of chemically combined chlorine atoms or a mixture of chlorine atoms and hydrogen atoms which are sufficient to substantially saturate dangling carbon atoms at diamond crystal grain boundaries,carbon dislocations, and carbon valance vacancies and (B) diamond crystal grain boundaries separating the columnar diamond crystals of (A), where the diamond crystal grain boundaries have a 70°-90° orientation to the diamond crystal base.

2. A diamond film in accordance with claim 1, having a thickness of up to 5000 microns.

3. A diamond film in accordance with claim 1, having a thickness between 200 microns and 1000 microns.

4. A method of making a non- adherent free-standing, semi-transparent polycrystalline diamond film on a substrate which method comprises, passing a mixture of hydrogen and a carbon-chlorine containing material through a heated reaction zone at a temperature of about 700°C to about 900°C and at a pressure from about 3 to about 24 torr which is sufficient to generate active atomic species comprising carbon-Cl species, or a mixture of carbon-Cl and carbon-hydrogen species, and the heated reaction zone maintained at a distance of from about 0.3 to about 1 centimeter from the surface of the substrate, where the carbon-chlorine containing material is a member selected from the group consisting of,
(a) a carbon polychloride, C(H)ₐCl₄-ₐ, where "A" is a whole number equal to 0 to 3 inclusive, and
(b) a mixture of the carbon polychloride and methane,
and the carbon-chlorine containing material introduced into the heated reaction zone is present at from about 0.1 to about 2 volume percent of carbon-chlorine containing material, based on the total volume of hydrogen and carbon-chlorine containing material in the mixture.

5. A method in accordance with claim 4, where the carbon-chlorine containing material is carbon tetrachloride.

6. A method in accordance with claim 4, where the carbon-chlorine containing material is a mixture of methane and carbon tetrachloride.
